Europäisches Patentamt

European Patent Office

Office européen des brevets

(19)

(11) Veröffentlichungsnummer : **0 093 290**
**B1**

(12)     EUROPÄISCHE PATENTSCHRIFT

(45) Veröffentlichungstag der Patentschrift :
30.12.86

(51) Int. Cl.⁴ : **H 05 K   7/10**

(21) Anmeldenummer : **83103572.0**

(22) Anmeldetag : **13.04.83**

(54) **Steckverbinder für I.C.-Baueinheiten.**

(30) Priorität : **21.04.82 DE 3214841**
**25.02.83 DE 8305384 U**

(43) Veröffentlichungstag der Anmeldung :
**09.11.83 Patentblatt 83/45**

(45) Bekanntmachung des Hinweises auf die Patenterteilung : **30.12.86 Patentblatt 86/52**

(84) Benannte Vertragsstaaten :
**AT BE CH DE FR GB IT LI LU NL SE**

(56) Entgegenhaltungen :
**FR-A- 2 312 119**
**US-A- 2 825 037**
**US-A- 3 130 351**
**US-A- 3 997 227**
**US-A- 4 193 656**
**US-A- 4 266 840**

(73) Patentinhaber : **Lotter, Karl**
**Falkenstrasse 2**
**D-8959 Buching (DE)**

(72) Erfinder : **Lotter, Karl**
**Falkenstrasse 2**
**D-8959 Buching (DE)**

(74) Vertreter : **Kuhnen, Wacker & Partner**
**Schneggstrasse 3-5 Postfach 1729**
**D-8050 Freising (DE)**

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

EP 0 093 290 B1

**Beschreibung**

Die Erfindung betrifft einen Steckverbinder für I.C.-Baueinheiten gemäß dem Oberbegriff des Anspruchs 1.

Ein derartiger Steckverbinder ist beispielsweise aus der US-PS-4 266 840 bekannt. Der darin beschriebene Steckverbinder weist zwei Klemmplattenteile auf, welche über eine oberhalb den Klemmplattenteilen angeordnete und gesonderte Scharnierverbindung diese schwenkbeweglich verbindet, so daß beim Einsetzen einer I.C.-Baueinheit in den Sockelkörper, die Unterseite der I.C.-Baueinheit auf die Schwenkverbindung drückt. Dabei werden mit zunehmender Einsetztiefe der I.C.-Baueinheit die Klemmplatten gegen die Sockelkontaktfedern gedrückt, welche ihrerseits die Anschlußbeine der I.C.-Baueinheit zunehmend fester gegen die von Randbereichen des Sockelkörpers gebildeten Stützflächen andrücken. Dies bedeutet, daß die I.C.-Baueinheit bereits während des Einsetzens in den Sockel zunehmend festgelegt wird und damit die Gefahr besteht, daß erstens die I.C.-Baueinheit nicht die vorgesehene Endposition erreicht und zweitens durch den zunehmenden Einsetzdruck die Anschlußbeine verbogen werden können, so daß Ungenauigkeiten bei einem gleichmäßigen Anpreßdruck der Sockelkontakte an die mehrfachen Anschlußbeine zu Störungen der elektrischen Funktion führen können. Ähnliche Probleme treten bei der in der US-PS-4 189 199 beschriebenen Sockelvorrichtung auf, bei welcher die I.C.-Baueinheit auf Plattenelemente und über diese betätigte Federkontakte während des Einsetzvorgangs drückt. Weitere Sockelhalter, bei welchen die Federkraft bereits während des Einsetzens der I.C.-Baueinheit in den Sockel durch den Einsetzvorgang wirksam wird, sind in der US-PS-3 883 2-07 und 3 750 085 mit den sich daraus ergebenden Nachteilen beschrieben. Wenn jedoch das Hauptanwendungsgebiet der Sockelkörper bei beispielsweise auf Leiterplatten angeordneten elektrischen Schaltungen angestrebt wird, bei welchen eine dauerhafte und zuverlässige Funktion der I.C.-Baueinheit erforderlich ist, dann ist von besonderer Bedeutung, daß erstens die I.C.-Baueinheit die gewünschte Position eindeutig erreicht und zum anderen möglichst jegliche Kontaktverbiegungen bei den Kontaktbeinen der I.C.-Baueinheit vermieden werden. Hierzu sind die soeben beschriebenen Sockelanordnungen wenig geeignet. Daher wurden Sockelanordnungen entwickelt, bei welchen die I.C.-Baueinheit erst in den Sockel eingesetzt und anschließend die Sockelbeine festgeklemmt werden. Solche Anordnungen sind beispielsweise in den US-PS-3 997 227 oder 4 054 347 oder 4 26-6 839 beschrieben, wo durch mittig angeordnete Stangen eine Druckkraft bzw. Zugkraft oder Drehschubkraft auf die Federkontakte ausgeübt wird. Da solche Anordnungen sehr aufwendig sind und bei der Preisrelation zu den I.C.-Baueinheiten wirtschaftlich nicht vernünftig herstellbar sind, konnten sich diese Anordnungen für die vorgesehenen Einsatzgebiete nicht durchsetzen.

Es wurde daher eine einfachere Lösung mit Kunststoffklappteilen vorgeschlagen, wie sie in der US-PS-4 193 656 beschrieben ist. Bei dieser Lösung dient die Klappvorrichtung aufgrund der gewählten Materialwahl gleichzeitig als Federelement, das auf die Anschlußbeine die gewünschte Federkraft aufbringen soll. Abgesehen von der Tatsache, daß diese Sockelkonstruktion den Nachteil hat, daß ebenfalls die Federkraft des Kunststoffbetätigungsteils bereits während des Einsetzens der I.C.-Baueinheit in den Sockel aufgebracht wird, besteht ein weiterer Nachteil darin, daß ein solch elastisches Kunststoffmaterial keine gleichmäßige Andruckkraft auf alle Anschlußkontakte gleichzeitig ausüben kann.

Eine andere Sockelausführung mit einem Klappmechanismus, der erst bei eingesetzter I.C.-Baueinheit betätigt wird, ist in der US-PS-3 820 0-54 beschrieben. Obwohl die darin beschriebene Lösung zunächst einfach erscheint, hat diese Sockelkonstruktion den Nachteil, daß sie nur als Einzelsockel mit großem Abstand zu anderen Sockeln angeordnet werden kann, weil die Seitenflächen des Sockels für die Betätigung der Klemmvorrichtung Abstand zueinander haben müssen.

Der Nachteil, nicht einen Sockel an einen anderen sowohl in Längsrichtung als auch in Querrichtung so ansetzen zu können, was bei gedruckten Schaltungen zunächst von Bedeutung ist, ob diese direkt mit I.C.-Baueinheiten oder mit dazwischengefügten Sockeln bestückt werden, haftet auch der Sockelanordnung gemäß der US-PS-4 266 840 an. Denn auch bei dieser Sockelanordnung ist die, durch die Konstruktion der Federkontakte bedingte Bauform, eine Identität zwischen Kontaktbeinen der I.C.-Baueinheit und Lötanschlußstiften des Sockels verschieden, so daß eine weitere platzsparende Konstruktion der Sockelseitenwände unberücksichtigt bleiben kann. Darüber hinaus hat die Sockelkonstruktion gemäß der US-PS-4 266 840 den Nachteil, daß eine gesonderte Sicherung über Sperrklinken vorgesehen werden muß, welche verhindert, daß bei Erschütterungen des Sockels sich die Klemmplatten entsprechend der auf sie wirkenden Federkräfte aus dem labilen Haltenzustand in den stabileren Lösezustand aufschwenken und damit die I.C.-Baueinheit in ihrem Kontakt zu den Sockelkontakten freigeben würden. Eine solche Klinkensicherung ist jedoch ein weiterer Nachteil, den eine einfache und preiswerte Sockelkonstruktion verbietet.

Es ist daher Aufgabe der Erfindung, einen Steckverbinder für I.C.-Baueinheiten gemäß dem Oberbegriff des Anspruchs 1 derart zu schaffen, daß der Steckverbinder in seinen Außenabmessungen und seiner Sockelkontaktanordnung bei nahezu allen Schaltungen die für die unmittelbare Bestükkung mit I.C.-Baueinheiten

vorgesehen sind, auch bei enger Gruppenanordnung einsetzbar ist und daß dieser Steckverbinder ein Festklemmen der I.C.-Baueinheit nach dessen Einsetzen in die Sockelkontakte einfach ermöglicht, ohne daß dabei auf eine besonders einfache und preiswerte Konstruktion verzichtet werden muß.

Diese Aufgabe wird durch die kennzeichnenden Merkmale des Anspruchs 1 gelöst. Vorteilhafte Weiterbildungen ergeben sich aus den Unteransprüchen.

Ein besonderer Vorteil der Erfindung ist darin zu sehen, daß der neue Steckverbinder auch für die nachträgliche Bestückung von bereits bestehenden gedruckten Schaltungen verwendet werden kann, weil beim Auslöten einer beschädigten I.C.-Baueinheit an deren Stelle der neue Steckverbinder eingelötet werden kann und damit werden die übrigen Elemente der gedruckten Schaltung nicht durch wiederholte Lötvorgänge gefährdet. Ein weiterer Austausch der einzelnen I.C.-Baueinheiten ist nämlich dann durch einfaches Öffnen und Schließen der Sockelkontakte möglich. Dies setzt jedoch voraus, daß die Abmessungen des neuen Steckverbinders im wesentlichen denen der I.C.-Baueinheit selbst entsprechen und darüber hinaus die Sockelkontakte Lötanschlußstifte oder Wrapanschlüsse aufweisen, welche in ihrer Anordnung der Anordnung der Anschlußbeine einer I.C.-Baueinheit entsprechen. So wird beispielsweise besonders vorteilhaft der Lötanschlußstift des neuen Steckverbinders mit quadratischem Querschnitt gewählt, weil dadurch ein « Aufschwimmen » des Sockels beim automatischen Löten in einem Lötbad nicht stattfinden kann, denn das flüssige Lot findet zwischen den Seitenwänden des im Querschnitt quadratischen Lötanschlußstiftes und dem Rundloch in der Leiterplatte genügend Platz, um durchzutreten und damit ein Aufschwimmen zu verhindern.

Ein weiterer wesentlicher Vorteil der Erfindung ist darin zu sehen, daß der neue Steckverbinder auch bei Erschütterungen die I.C.-Baueinheit sicher festhalten kann, da die Klemmplatten in der Arretierungsstellung eine stabile Lage haben, und bei Erschütterungen erst in die noch stärker federbelastete Spannstellung überführt werden müßten, daß sie aus der labilen Spannstellung in eine wieder stabile Lösestellung gelangen können. Durch die Schaffung einer über die Spannstellung hinausgehenden Arretierungsstellung wird somit eine besonders einfache und doch äußerst wirksame Sicherung der eingesetzten I.C.-Baueinheiten erreicht.

Damit die Konstruktion des neuen Steckverbinders auch bei Lösestellung einfach bleibt, ist einerseits vorgesehen, daß die Scharnierverbindung zwischen den Klemmplattenteilen eine Schwenkwinkelbegrenzung aufweist, so daß die auch in Lösestellung auf die äußeren Klemmplattenränder wirkenden Federkräfte die Klemmplattenvorrichtung in eingespannter Anordnung in der Sockelvorrichtung festhalten. Dies bedeutet, daß bei dem neuen Steckverbinder die äußeren Klemmplattenränder unmittelbar von den Federkontakten und nicht durch gesondert auszubildenden Halteprofilelemente gehalten werden, was sowohl konstruktiv als auch kostenmäßig aufwendig wäre. Vorteilhafterweise werden die Halteprofile und die Form der äußeren Klemmplattenränder bogensegmentförmig oder sogar kreisbogensegmentförmig ausgebildet, so daß die Klemmplattenränder als Lager und die Federelemente als Lagerschalen dienen können. In diesem Lager vorgesehene Querrillen erhöhen bei der durch das Lager einerseits erzielbaren präzisen Führung andererseits die Reibkräfte, so daß ein gezieltes Überführen von der Lösestellung über die Spannstellung in die Arretierstellung und zurück möglich ist. Für diesen Zweck wird vorteilhafterweise an wenigstens einer Stirnseite der Klemmplattenteile ein Betätigungszapfen ausgebildet, welcher auch beidseitig angeordnet sein kann. Hierzu eignet sich besonders vorteilhaft die gewählte Konstruktion der an die Klemmplatten angeformten Scharnierteile und/oder der Scharnierstift der Schwenkverbindung.

Da die Arretierstellung nur durch einen Anschlagpunkt für die Klemmplattenvorrichtung an der Oberseite des Sockelkörpers ausgebildet sein muß, würde grundsätzlich das Vorsehen eines entsprechenden Anschlags an der Oberseite des Sockelkörpers für diesen Zweck ausreichen. Es ist jedoch besonders vorteilhaft, die Oberfläche des Sockelkörpers V-förmig mit einem dazwischen befindlichen großen Winkel auszubilden, weil damit bei Erschütterungen nicht Punktbelastungen auf die Klemmplattenvorrichtung übertragen werden, sondern weil dadurch Klemmplattenanlageflächen erreicht werden können, welche die nachteiligen Punktbelastungen ausschließen und damit zu einer weiteren Sicherung der Klemmplattenteile in der Arretierstellung beitragen. Die Ausbildung dieser Klemmplattenanlageflächen kann bereits bei der Herstellung des Klemmplattenkörpers im Druck- oder Spritzverfahren ohne wesentliche zusätzliche Werkzeugkosten berücksichtigt werden.

Ebenso einfach und damit vorteilhaft ist die Ausbildung der Sockelkontakte, die weitgehend oder ganz einstückig ausgebildet in den Sockelkörper eingepreßt werden können. Da die oberen Endbereiche der Sockelkontakte als Federzungen ausgebildet sind, liefern sie den gewünschten Federdruck auf die äußeren Klemmplattenränder. Um die Federzungen mit den Sockelkontakten unter eine entsprechende Vorspannung in den Sockelkörper einsetzen zu können, ist besonders vorteilhaft, wenn eine Federzungenanlagefläche an der Oberseite des Sockelkörpers ausgebildet ist, die sich in Form einer Kerbe in den Sockelkörper hinein erstrecken kann. Hierzu genügt, wenn die Federzunge mit der Federzungenanlagefläche einen kleinen Winkel einschließt, der im wesentlichen den Federweg bestimmt.

Bei einer einfacheren Ausführungsform des neuen Steckverbinders werden die Kontaktbeine der I.C.-Baueinheit von der Federzunge gegen eine Stützfläche gepreßt, welche von einem hochgezogenen Rand des Sockelkörpers gebildet wird. Dieser hochgezogene Rand kann vorteilhafterweise eine Einlaufschräge aufweisen, die das Einsetzen der I.C.-Baueinheit in den Sockel erleichtert.

Bei einer anderen Ausführungsform des neuen Steckverbinders wird die Stützfläche von einem Stützkontakt gebildet, der am oberen Endbereich des Sockelkontakts mit diesem ausgebildet ist, so daß der obere Endbereich des Sockelkontakts einerseits aus der Federzunge und andererseits aus dem Stützkontakt besteht. So kann beispielsweise eine tulpenähnliche Lösung für den oberen Endbereich des Sockelkontakts gewählt werden, bei welchem durch zwei entsprechende Einschnitte ein Teil des Sockelkontakts als Federzunge ausgebildet wird. Wenn besonders hohe Festhaltekräfte angestrebt werden, dann wird der Stützkontakt weitgehend massiv mit dem Sockelkontakt ausgebildet und eine separate Federzunge mit dem Sockelkontakt verbunden, so daß sich die Federzunge vom unteren Endbereich durch den mittleren Haltebereich in den oberen Endbereich des Sockelkontakts erstreckt. Bei einer solchen Ausführungsform kann dann vorteilhafterweise der Stützkontakt einen Kopfabschnitt aufweisen, der dem Stützkontakt im oberen Bereich eine weitere Festigkeit verleiht und der eine nasenförmige Kontaktfläche aufweist, wodurch eine stärker punktförmige und weniger flächenförmige Belastung auftritt, was zu einem intensiveren Kontakt zwischen Kontaktbein der I.C.-Baueinheit und dem Sockelkontakt führt. Durch den Stützkontakt wird neben den Elastizitätsmodulen in der Klemmplatte und im wesentlichen in der Federzunge ein weiteres Elastizitätsmoment erreicht. Dies ist besonders deshalb wichtig, weil aufgrund der geringen Konstruktionsabmessungen möglichst alle Teile des neuen Steckverbinders funktionell ausgenützt werden müssen.

Hierzu ist ein weiterer Vorteil, wenn der Stützkontakt in einem geringen Abstand auf eine Stützkontaktanlagefläche trifft, die im Sockelkörperrand ausgebildet sein kann und damit einerseits ein Überdehnen der Stützkontakte beim Einsetzen von I.C.-Baueinheiten oder beim sonstigen Hantieren an den Kontakten verhindert und andererseits die Gefahr einer Kontaktberührung mit einem Nachbarkontakt des benachbarten Sockels verhindert.

Natürlich kann der neue Steckverbinder auch mit Prüfsockelhalterungen zu einem ausgesprochenen Prüfsockel-Steckverbinder ausgebildet werden, indem der neue Steckverbinder lediglich mit Betätigungszapfen versehen wird, welche vorteilhaft die Scharnierzapfen sind, die in eine entsprechende Hebelvorrichtung eines Prüfsockels hineinreichen. Dadurch wird auch für den Bereich der Prüfsockel eine vielseitige Anwendbarkeit des neuen Steckverbinders erreicht, was ein weiterer Vorteil für eine einheitliche Konstruktion des Steckverbinders ist. Weitere Vorteile und Einzelheiten der Erfindung ergeben sich aus der nachfolgenden Beschreibung anhand der beigefügten Zeichnung.

Darin zeigt :

Figur 1 einen Schnitt quer zur Längsrichtung des Steckverbinders, bei welchem die Klemmplattenteile einmal in Lösestellung und gestrichelt in Spannstellung dargestellt sind ;

Figur 2 eine ähnliche Darstellung wie in Fig. 1, wobei jedoch die Klemmplattenteile in Arretierstellung gezeigt sind und wobei die I.C.-Baueinheit im ganzen dargestellt ist ;

Figur 3 die Queransicht einer ersten Ausführungsform des Sockelkontakts, der bei einer Ausführungsform gemäß Fig. 1 und 2 verwendet wird ;

Figur 4 die Längsansicht des Sockelkontakts gemäß Fig. 3 ;

Figur 5 eine Queransicht der Klemmplattenvorrichtung ;

Figur 6 eine Draufsicht auf die Klemmplattenvorrichtung gemäß Fig. 1 und 2 und 5 ;

Figur 7 einen Schnitt durch einen Sockelkörper, in welchen noch keine Sockelkontakte eingesetzt sind ;

Figur 8 eine Draufsicht auf den Sockelkörper gemäß Fig. 7 ;

Figur 9 einen Schnitt durch eine andere Ausführungsform eines Sockelkontakts, bei welchem die Stützfläche mit dem Sockelkontakt ausgebildet ist ;

Figur 10 eine weitere Ausführungsform des Sockelkontakts ähnlich gemäß Fig. 9, welcher tulpenförmig ausgebildet ist ;

Figur 11 eine weitere Ausführung eines Sockelkontakts mit einem besonderen Stützkontakt und daran ausgepaßten Sockelkörper ;

Figur 12 eine Seitenansicht einer Hebelvorrichtung eines Prüfsockels ; und

Figur 13 eine Draufsicht auf die Hebelvorrichtung gemäß Fig. 12.

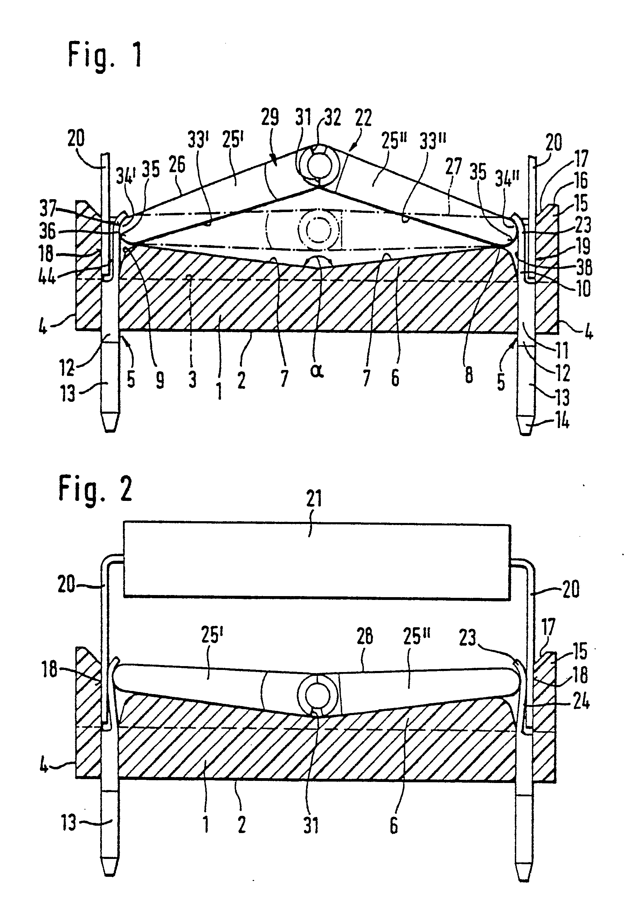

Gemäß Fig. 1 weist ein Sockelkörper 1 eine Unterseite 2, eine Oberseite 3 und seitliche Längsseiten 4 auf. Die Oberseite 3 des Sockelkörpers 1 wird zwischen in den Sockelkörper 1 eingesetzte Sockelkontakte 5 von einem Klemmplattenanlageflächenabschnitt 6 überdeckt, an dessen freier Oberseite die Klemmplattenanlagefläche 7 ausgebildet ist. Die Klemmplattenanlagefläche 7 ist V-förmig von der Sockelkörpermitte aus ausgebildet und schließt einen stumpfen Winkel $\alpha$ von cica 165° ein. Natürlich kann der Winkel $\alpha$ je nach Einsatzzweck des Sockelkörpers für einen Bereich von 180° und 150° dieselbe erfindungsgemäße Funktion ausüben. An den äußeren Grenzlinien 8 der Klemmplattenablagefläche 7 geht diese in eine Federzungenanlagefläche 9 über, welche sich relativ steil nach unten zur Sockeloberseite 3 erstreckt, wo der Sockelkontakt 5 mit einem oberen Endbereich 10 aus der Sockelkörperoberseite 3 herausragt, während ein mittlerer haltebereich 11 des Sockelkontakts 5 mit einem Preßsitz in dem Sockelkörper 1 befestigt ist. Von der Unterseite 2 des Sockelkörpers 1 steht ein unterer Endbereich 12 des Sockelkontakts 5 senkrecht nach unten ab und geht in einen Lötanschlußstift 13 über, welcher im Querschnitt vierkantförmig ausgebildet ist und eine Spitze 14 aufweist, die zur leichteren Einführung des Lötanschlußstiftes 13 beispielsweise für die Bohrungen von Leiterplattenlöchern dient.

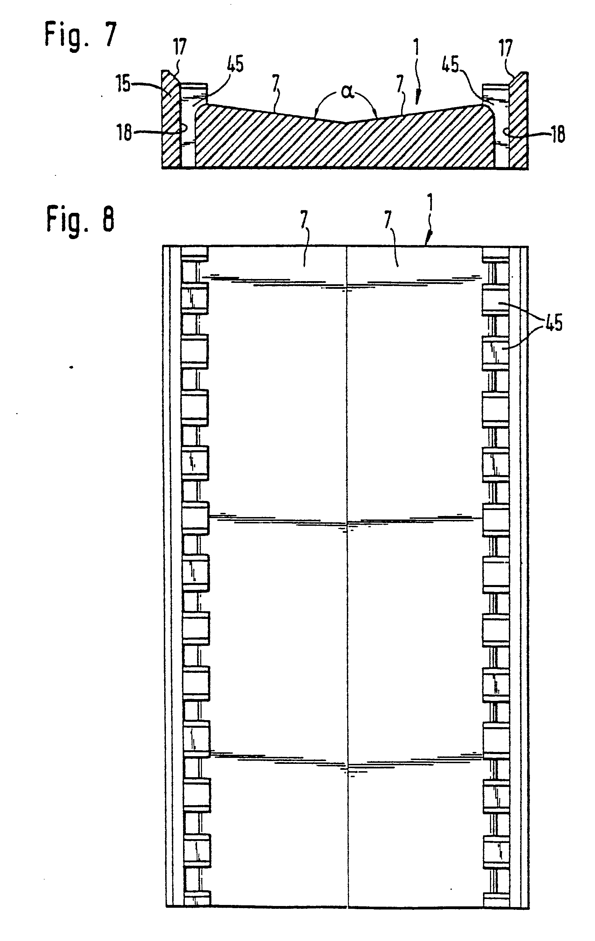

Die Längsseiten 4 des Sockelkörpers 1 gehen in einen Sockelrand 15 über, der an seiner oberen Stirnseite 16 eine Einlaufschräge 17 aufweist, die von der oberen Stirnseite 16 schräg nach unten zur Sockelmitte hin zeigt und bis zu einer inneren Sockelrandseitenfläche 18 reicht, wie insbesondere in Fig. 7 dargestellt.

An dieser Stelle sei darauf hingewiesen, daß einander entsprechende Teile in allen Figuren mit gleichen Bezugszeichen versehen sind, so daß eine gesonderte Beschreibung hierfür entfallen kann.

Der innere Seitenrand 18 dient bei dieser Ausführungsform als Stützfläche 19 für ein Anschlußbein 20 bei der I.C.- Baueinheit 21, das in den Sockel 1 eingesteckt ist und von einer Klemmvorrichtung 22 gemäß der Darstellungsform von Fig. 2 mit der Rücken- Fläche 24 einer Federzunge 23 gegen den inneren Seitenrand 18 des Sockelrandes 15 festgeklemmt wird.

Dabei ist in Fig. 1 die aus einem linken Klemmplattenteil 25' und einem rechten Klemmplattenteil 25" zusammengesetzte Klemmvorrichtung 22 in Lösestellung 26 mit ausgezogenen Linien und eine Spannstellung 27 mit gestrichelten Linien dargestellt, während eine Arretierstellung 28, die auch der Betriebstellung entspricht in Fig. 2 dargestellt ist.

Die Klemmvorrichtung 22 weist eine Schwenkverbindung 29 auf, welche die beiden Klemmplattenteile 25' und 25" mittels Gelenkachsenrasten 30 verbindet. In der Darstellung gemäß Fig. 2 weisen die beiden Klemmplattenteile 25' und 25" eine im Bereich des Gelenkachsenrasten 30 ausgebildete Schwenkwegbegrenzung 31 auf, welche bei der Lösestellung 26 gemäß Fig. 1 durch gegenseitigen Anschlag aneinander den Schwenkweg über die Lösestellung hinaus begrenzt. Ebenso ist an der Oberseite der beiden Klemmplattenteile 25' und 25" eine obere Schwenkwegbegrenzung 32 vorgesehen, die einen Schwenkweg nach unten über die Arretierstellung 28 hinaus begrenzen kann, weil dadurch bei der Herstellung und Montage der Klemmvorrichtung 22 eine bessere Arbeitsvorbereitung möglich ist. Von der Funktion der Klemmvorrichtung 22 selbst ist es bei der gezeigten Ausführungsform nicht notwendig, eine obere Schwenkwegbegrenzung 32 vorzusehen, da die Unterseite 33' bzw. 33" der Klemmplattenteile 25' bzw. 25" ohnehin in Arretierstellung 28 an der Klemmplattenanlagefläche 7 anliegt und damit den Schwenkweg begrenzt.

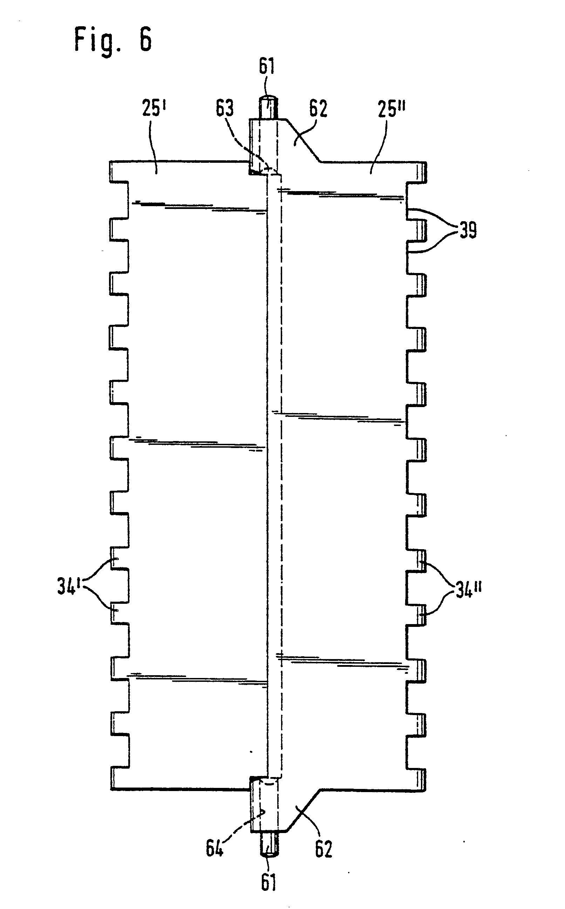

Die äußeren Klemmplattenränder 34' bzw. 34" weisen eine vorzugsweise kreisbogenförmige Bogenkontur 35 auf, welche zumindest teilweise der Kreisbogenkontur 37 der Halteprofilelemente 36 entsprechen und an einer Vorderfläche 38 der Federzunge 23 anliegen. Zwischen den äußeren Klemmplattenrändern 34' und 34" sind Vorsprünge 39 — wie in Fig. 6 dargestellt — vorgesehen, welche sich zwischen die Sockelkontakte 5 erstrecken.

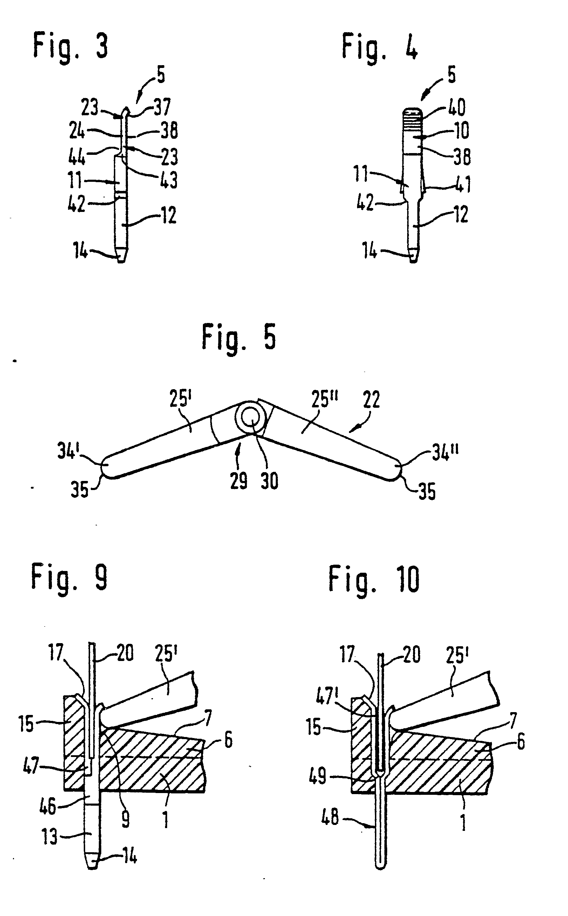

Gemäß Fig. 3 ist ein einzelner Sockelkontakt 5 in Queransicht dargestellt, und gemäß Fig. 4 ist derselbe Sockelkontakt 5 in Längsansicht dargestellt, wobei deutlich Querrillen 40 zu erkennen sind, welche in Reibwirkung mit den Anschlußbeinen 20 der I.C.-Baueinheit 21 zusammenwirken. Außerdem ist bei der Darstellung gemäß Fig. 4 zu erkennen, daß Verankerungshaken 41 vorgesehen sind, mit welchen der Sockelkontakt 5 in seinem Preßsitz zusätzlich im Sockelkörper 1 verankert werden kann. In der Höhe etwa des Verankerungshakens 41 geht der Sockelkontakt 5 in den unteren Endbereich 12 über, wo ein Übergangsabsatz 42 in einen Vierkantquerschnitt übergeht. An der oberen Grenze des mittleren Haltebereiches 11, an der die Federzunge 23 gemäß Fig. 3 bis zu einem Federzungenende 43 reicht, ist ein Kontaktraum 44 vorgesehen, der gleichzeitig den Abstand zwischen der Stützfläche 19 und der Rückenfläche 24 der Federzunge 23 begrenzt. Die Federzunge 23 ist bei der erfindungsgemäßen Ausführungsform als Halteprofilelement 36 mit der Bogenkontur 37 ausgebildet, wie ebenfalls in Fig. 3 dargestellt.

In Fig. 5 ist nochmals die Klemmvorrichtung 22 in der Lösestellung 26 dargestellt, wie die Klemmvorrichtung 22 vor der Montage in den Sockelkörper 1 eingesetzt wird und dann die Position gemäß Fig. 1 in ausgezogenen Linien aufweist.

Gemäß Fig. 7 ist der Sockelkörper 1 ohne Sockelkontakte 5 und Klemmvorrichtung 22 dargestellt. Dabei wird der hochgezogene Sockelrand 15 mit der zugehörigen Einlaufschräge 17 deutlicher dargestellt. Zudem sind die Aufnahmekammern 45 zu erkennen, in welche die Sockelkontakte 5 eingesetzt werden.

Gemäß Fig. 8 ist eine Draufsicht auf den Sockelkörper 1 gemäß Fig. 7 dargestellt, bei dem die Aufnahmekammern 45 und die Einlaufschräge 17 in Draufsicht zu erkennen sind. Ebenso sind die Zwischenräume zwischen den einzelnen Aufnahmekammern 45 dargestellt, in welche die Klemmplattenvorsprünge 39 eingreifen und damit ein Verrutschen der Klemmvorrichtung 22 in Sockellängsrichtung verhindern.

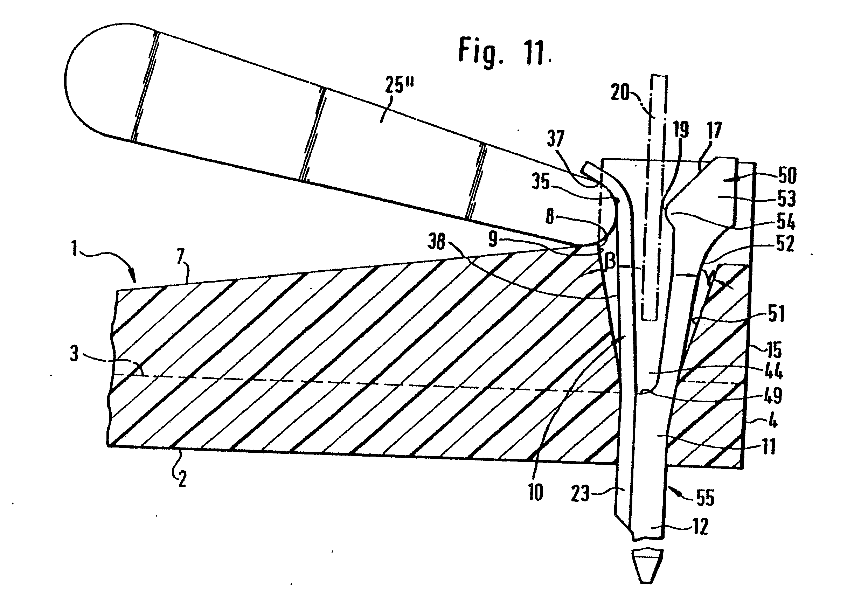

Gemäß Fig. 9 ist eine andere Ausführungsform eines Sockelkontaktes 46 dargestellt, bei welchem der innere Seitenrand 18 von einem Stützkontakt 47 abgedeckt ist, so daß das Anschlußbein 20 der I.C.-Baueinheit 21 nicht gegen den inneren Seitenrand 18 sondern gegen den Stützkontakt 47 geklemmt wird, welcher dadurch die Funktion der Stützfläche 19 bildet. Da der Stützkontakt 47 den Kontaktraum 44 teilweise ausfüllt, wird dadurch das Spiel für das Anschlußbein 20 der I.C.-Baueinheit 21 beim Einsetzen des Anschlußbeins 20 wesentlich eingeschräkt. Der Stützkontakt 47 ist bis zu der Einlaufschräge 17 hochgezogen, so daß ein Hängenbleiben der Anschlußbeine 20 beim Einsetzen der

I.C.-Baueinheit 21 und damit eine Beschädigungsgefahr reduziert wird.

Gemäß Fig. 10 ist eine weitere Ausführungsform für einen anderen Sockelkontakt 48 dargestellt, bei welchem ebenfalls ein Stützkontakt vorgesehen ist und der Sockelkontakt 48 und der Stützkontakt 47 eine tulpenförmige Ausbildung aufweisen, wobei der Tulpenboden 49 in den Sockelkörper 1 hineinragt und damit eine niedrigere Bauhöhe für den mit I.C.-Baueinheit bestückten Sockelkörper erreicht wird. Zudem ist der Sockelköntakt 48 längsgeteilt, während der Sockelkontakt 46 gemäß Fig. 9 dieselbe Ausführungsform wie der Sockelkontakt 5 aufweist und lediglich durch den Stützkontakt 47 ergänzt ist.

Bei der Ausführungsform gemäß Fig. 11 ist der Stützkontakt 50 als Hauptkontakt ausgebildet und die Federzunge 23 weist eine in den mittleren Haltebereich 11 bis in den unteren Endbereich 12 reichende Verlängerung auf. Bei der Ausführungsform gemäß Fig. 11 ist dabei die Federzunge 23 an den massiv ausgebildeten Stützkontakt 50 angenietet oder angeschweißt. Natürlich kann der Stützkontakt 50 auch einstückig mit der Federzunge 23 ausgebildet sein. Ferner ist bei der Ausführungsform gemäß Fig. 11 die Klemmplattenanlagefläche 7 etwas weiter in den Kontraktraum 44 hineinverlängert, als dies bei der Ausführungsform gemäß Fig. 1 der Fall ist, wo die Klemmplattenanlagefläche 7 nach der äußeren Grenzlinie 8 in eine Rundung übergeht, wie deutlich aus Fig. 7 ersichtlich. Bei der Ausführungsform gemäß Fig. 11 reicht daher die Federzungenanlagefläche 9 von der Oberseite 3 des Sockelkörpers 1 bis zu der Klemmplattenanlagefläche 7 in einem ebenen Verlauf. Die Federzungenanlagefläche 9 bildet mit der Vorderfläche 38 der Federzunge 23 einen spitzen Winkel β, welcher in der Größenordnung von 0° bis circa 30° und vorzugsweise 15° je nach Stellung der Klemmvorrichtung 22 liegt. Der Sockelrand 15 weist ferner eine Stützkontaktanlagefläche 51 auf, welche mit einer Rückseite 52 des Stützkontaktes 50 einen spitzen Winkel α einschließt. Der je nach Belastung des Stützkontaktes zwischen > 0° und circa 30° vorzugsweise 15° beträgt. Die Anlagefläche 51 dient im wesentlichen dazu, daß der Stützkontakt 50 nicht über die äußere Längsseite 4 des Sockelkörpers 1 hinaus verbogen werden kann und damit die Gefahr herbeigeführt wird, daß mit dem entsprechenden Stützkontakt 50 eines Nachbarsockels eine unerwünschte Stromverbindung hergestellt wird. Der Stützkontakt 50 weist einen Kopfbereich 53 auf, der im wesentlichen wie der Sockelrand 15 gemäß der Ausführungsform von Fig. 1 ein Einlaufschräge 17 aufweist. Die Einlaufschräge 17 geht in einen Nasenvorsprung 54 über, der an seiner Vorderseite die Stützfläche 19 bzw. eine Kontaktzone trägt, welche eine mehr punktförmige Belastung auf das Anschlußbein 20 einer I.C.-Baueinheit 21 ausüben kann.

Damit nimmt bei der Ausführungsform gemäß Fig. 11 der Stützkontakt 50 die Hauptdruckkräfte auf das Anschlußbein 20 mit einem gewissen Elastizitätsbereich auf, während die Federzunge 23 zunächst den Hauptfederweg bildet und dann die wesentlichen Druckkräfte der Klemmvorrichtung 22 von den Klemmplattenteilen 25 durch das massive Material der Federzunge 23 von der Vorderfläche 38 auf die Rückenfläche 24 und damit auf das Anschlußbein 20 überträgt. Damit hat die Federzunge 23 eine Hilfskontakt- und eine Halteprofilfunktion, wobei natürlich die Hauptfunktion in der Einleitung der Federkräfte für die Klemmvorrichtung besteht. Der Kontaktraum 44 wird durch die Rückenfläche 24 der Federzunge 23 und durch die Vorderfläche des Stützkontakts 50 seitlich und nach unten durch den Tulpenboden 49 begrenzt. Wenn der Sockelkörper 1 einstückig ausgebildet ist, d. h. mit dem Klemmplattenanlagenflächenabschnitt 6 und dem Sockelrand 15 in einstückiger Ausbildung, dann wird durch die Federzungenanlagefläche 9 auf der einen Seite und der Stützkontaktanlagefläche 51 auf der Sockelrandseite eine Einkerbung gebildet, in welche der aus Federzunge 23 und Stützkontakt 50 zusammengesetzte Sockelkontakt 55 eingesetzt werden kann.

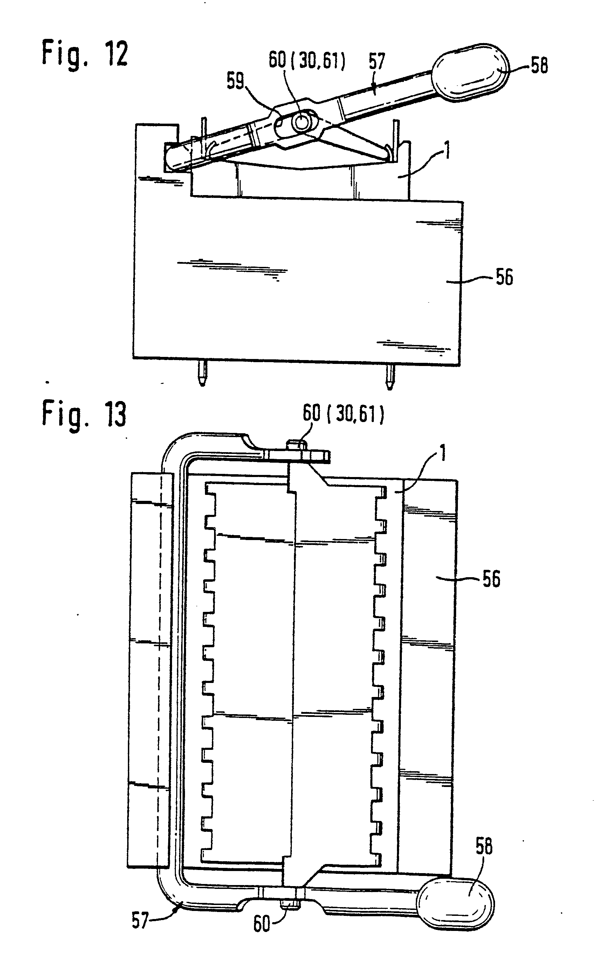

Gemäß Fig. 12 ist ein Prüfsockel 56 dargestellt, der eine Hebelvorrichtung 57 aufweist. In dem Betätigungshebel 58 ist eine Aussparung 59 vorgesehen, in welche ein Betätigungszapfen 60 ragt. Der Betätigungszapfen 60 kann die Gelenkachsenraste 30 sein, der entweder unmittelbar verlängert oder über einen Mitnehmer 61 in die Aussparung 59 ragt und damit über den Betätigungshebel 58 eine Schwenkung der Klemmvorrichtung 22 von der Lösestellung über die Spannstellung 27 in die Arretierstellung 28 und zurück ermöglicht. In Fig. 13 ist eine Draufsicht auf die Vorrichtung gemäß Fig. 12 dargestellt, die im wesentlichen der Draufsicht auf die Darstellung gemäß Fig. 6 entspricht, bei welcher ebenfalls die Betätigungsansätze 62 mit zugehörigen Rastbolzen 63 vorgesehen sind. Die Rastbolzen 63 können dabei an einem Klemmplattenteil 25' in einer geringen Vorsprungswölbung ausgebildet sein, so daß sie in Bohrungen 64 der Betätigungsansätze 62 aufgrund einer elastischen Verformung der Betätigungsansätze 62 beim Zusammenfügen einrasten können. Dabei sind die Betätigungsansätze 62 in dem Klemmplattenteil 25″ ausgebildet. In die Bohrungen 64 der Betätigungsansätze 62 können dann Gelenkachsenzapfen 30 eingesetzt werden, welche in ihrer Verlängerung in die Hebelvorrichtung 57 ragen oder es wird bei einer anderen Ausführungsform ein Zapfen der Hebelvorrichtung 57 in die Bohrung 64 des Betätigungsansatzes 62 eingeführt.

Mit den vorstehend geschilderten Merkmalen der Erfindung können für Serienfabrikation geeignete Steckverbinder bzw. -sockel geschaffen werden, welche einfach aus Isolierstoff herstellbar sind und in dessen darin vorgesehene Kontaktkammern Sockelkontakte eingepreßt werden können. Da die Packungsdichte der Halbleiter eine geringe Baugröße der Sockelkörper erfordert, müssen diese von vier Seiten reihbar anzuordnen sein, was nur mit einem Sockel gemäß der vorliegenden Erfindung möglich ist. Da sehr hohe Anforderungen an die elektrischen und mechanischen Eigenschaften gestellt werden, müssen in dem zur Verfügung stehenden begrenzten Raum Miniaturkontakte mit vorgespannten Kontaktfedern Platz finden. Um die elektrischen Bedingungen zu erfüllen und die Halbleiterbauelemente vor dem Lösen und Herausfallen durch Vibrationen und andere nachteilhafte Umgebungsbedingungen zu bewahren, muß mit relativ hohen Federkräften auf geringem Raum gearbeitet werden, ohne daß durch stark vorgespannte Federkontaktschenkel wie bei bekannten Vorrichtungen Beschädigungen der Kontaktstellen und hohe Einsteck- und Ausziehkräfte erforderlich sind.

Bei Vibrationen in ungünstigen Frequenzbereichen können die Federkontakte durch sekundäre Eigenschwingungen ihre Haltekraft verlieren, so daß ein Herausfallen der Halbleiter aus der Sockelhalterung oder zumindest Kontaktschwankungen die Folge sein können. Dies ist speziell in Luft- und Raumfahrtbereichsanwendungen sowie bei der Galvanotechnik und in anderen wichtigen Anwendungsbereichen ein nicht tolerierbarer Nachteil, der durch die vorliegende Erfindung vermieden wird. Ferner ist die Langzeitfunktion von weichen Kontaktfedern für I.C.-Baueinheiten unter umgebungsbedingten Einflüssen, wie Hitze, Kälte, aggressiven Industrieatmosphäre, Luftfeuchtigkeit usw. häufig nicht gewährleistet.

Da mit hohen Federkräften auf geringstem Raum gearbeitet werden muß, ist in vielen Fällen die Verwendung hochwertiger Spezialkontakt-Werkstoffe, Edelmetalle, Edelmetallplattierungen und demzufolge eine komplizierte und teuere Fertigungsmethode erforderlich, was ebenfalls durch die vorliegende Erfindung vermieden wird. So wird zudem bei hochwertigen Steckverbindern der « Dual-in-line »-Reihe aus mehreren Kontakteilen gebildet, wobei in eine gedrehte Außenhülse eine vergoldete Innenfeder eingepreßt wird, wodurch zusätzliche Spannungsverluste und Korrosionsgefahr resultieren können. Dies ist insbesondere auch unter Berücksichtigung der Sockel für Hochfrequenzanwendungen zu berücksichtigen. Ein weiterer Nachteil, der durch die vorliegende Erfindung vermieden wird, besteht darin, daß bei Billigsockeln die Gefahr besteht, daß der Verbindungsstecker hintersteckt werden kann, d. h., daß das Anschlußbein 20 beim Einführen hinter oder neben die Kontaktschenkel der Steckverbinderkontakte gelangt. Hierzu hat sich ein weiterer Nachteil von Billigsockeln dadurch gezeigt, daß zur Leiterplatte hin offene Aufnahmekammern immer wieder beim Einlöten flüssiges Lot und Lotdämpfe in die Kontaktzonen eindringen lassen und dadurch einen sicheren Kontaktschluß verhindern. In diesem Zusammenhang ist selbst bei hochwertigen Steckverbindern auch das Aufschwimmen beim automatischen Einlöten im Lötbad ein Problem, das eingangs bereits beschrieben worden ist. Der Absatz zwischen Lötanschluß, Stift und Mittelteil hat daher die Aufgabe, daß die Zentrier- und Auflagefunktion des Steckverbinders gegenüber der Leiterplatte gewährleistet wird und verschließt durch die Übergangsschräge die Leiterplattenbohrung von oben dicht ab, was durch das heisse Lot zu einem Aufschwimmen des gesamten Sockels führen kann, sofern nicht die erfindungsgemäß vorgesehenen Merkmale dies verhindern.

Bei der Bewertung des erfindungsgemäßen Steckverbinders ist daher von Bedeutung, daß der Kontaktschluß aller Anschlußbeine einer I.C.-Baueinheit möglichst gleichzeitig und durch mechanische Klemmung erfolgen muß. Darüber hinaus soll das Ein- und Ausstecken der Anschlußbeine der I.C.-Baueinheit zuverlässig, ohne Kraftaufwand und Reibung an den Kontaktstellen möglich sein und der Kontaktschluß soll absolut sicher sein, ohne Rücksicht auf Vibrationen und andere umgebungsbedingte Einflüsse. Diese Eigenschaften dürfen auch bei hoher Steckhäufigkeit nicht leiden, sondern müssen einen einwandfreien Kontaktschluß gewährleisten. Durch die einfache Konstruktion sollen teure Kontaktmaterialien und Edelmetallbeschichtungen sowie komplizierte Herstellverfahren verzichtbar sein, was beispielsweise durch einen nicht hinsteckbaren einstückig ausgebildeten Kontakt erreicht wird, der in seiner Formgebung bereits eine Kontaktgabe im oberen Teil des Steckverbinders zuverlässig erreicht. Die Unterseite des Sockels soll absolut lötdicht abgeschlossen sein und die Lötstifte so ausgebildet sein, daß beim automatischen Löten im Lötbad keine Aufschwimmgefahr besteht. Somit ergeben sich zusammengefaßt die Vorteile in Abgrenzung gegenüber den vorstehend aufgezeigten Anforderungen dadurch, daß mit mechanische Druckbeaufschlagung ein hoher Kontaktdruck gleichmäßig auf alle Anschlußbeine einer Halbleiterbaueinheit ausgeübt wird und durch die große Kontaktöffnung bei Lösestellung ein Einlegen und Herausnehmen der Halbleiterbaueinheit leicht und ohne Reibung möglich ist. Absolute Kontaktsicherheit ist auch bei Vibrationen und Umgebungseinflüssen wie Temperaturschwankungen, Industrieatmosphäre und dergleichen gegeben. Die Klemmplatten sind auch bei eingelötetem Sockelkörper jederzeit einfach und schnell auswechselbar, wenn diese versehentlich beschädigt worden sind. Eine Kontaktfertigung aus teurem Spezialkontaktfedermaterialien, wie z. B. Kupfer-Berylium, Edelmetallplattierungen und Goldauflagen ist nicht erforderlich und die Herstellung der Kontakte ist äußerst einfach und kostengünstig ohne technische Risiken durchführbar, wobei die einfache Formgebung auch dazu beiträgt, daß die Kontaktgabe bereits sicher im oberen Bereich des Kontaktschenkels erfüllt ist und durch die Querrillen im Kontaktbereich der Kontaktschenkel zusätzlich eine absolut sichere Kontaktgabe auch bei oxydierten Verbindungssteckern gewährleistet. Da der Kontakt durchgehend einstückig ausgebildet wird, können Übergangsverluste vermieden werden und durch die feste Anlage an den Klemmplatten bzw. an dem Sockelrand besteht keine Gefahr des Hintersteckens. Durch den festen Preßsitz der Kontakte sind diese gegen Eindringen von Lötmitteln und flüssigem Lot absolut dicht und durch den quadratischen Querschnitt des Lötanschlusses ist ein Aufschwimmen des Sockels beim automatischen Löten im Lötbad nicht zu befürchten, weil das flüssige Lot seitlich genug Platz findet, um an den Lötpfosten entlang an die Oberseite der Leiterplatte zu gelangen. Durch die Abmessungen ist eine Reihbarkeit von allen Seiten gewährleistet und durch das platzsparende Klemmsystem wird im geschlossenen und verriegelten Zustand keine Steigerung der Bauhöhe erforderlich.

**Patentansprüche**

1. Steckverbinder für IC-Baueinheiten
   a) mit einem isolierenden Sockelkörper
   b) mit mehreren Sockelkontakten,
      b1) welche im Sockelkörper den mehrfachen Anschlußbeinen einer IC-Baueinheit entsprechend angeordnet sind und
      b2) welche jeweils einen als Lötanschlußstift ausgebildeten unteren Endbereich aufweisen, der von der Bodenseite des Sockelkörpers senkrecht absteht,
      b3) weiter einen mittleren Haltebereich aufweisen, der zumindest teilweise formschlüssig in dem Sockelkörper befestigt ist und sich durch den Sockelkörper hindurch erstreckt, und
      b4) schließlich einen oberen Endbereich aufweisen, der als Anschlußelement von der Oberseite des Sockelkörpers absteht und wenigstens in einem Teil seiner Erstreckung als Federelement ausgebildet ist, das entlang jeweils eines quer zur Sockelkontakt-Längsrichtung verlaufenden Federweges verschiebbar ist, wobei die Federelemente zu einer entlang den Längsseiten an der Oberseite des Sockelkörpers vorgesehenen Stützfläche in einem so bemessenen Abstand angeordnet sind, daß dazwischen die Anschlußbeine der IC-Baueinheit einsetzbar sind, und
   c) mit einer Klemmvorrichtung, welche mindestens zwei Klemmplattenteile mit einer in ihrer Längsrichtung verlaufenden Schwenkverbindung aufweist und deren äußere Klemmplattenränder von Halteprofilelementen umfaßt sind und sowohl in einer Lösestellung als auch in einer Spannstellung der Klemmplattenteile an den Federelementen anliegen, wobei in Lösestellung die Klemmplattenteile nach oben geneigt von der Oberseite des Sockelkörpers giebelförmig weggerichtet sind und wobei in Spannstellung die Klemmplattenteile eine zur Bodenseite des Sockelkörpers parallele Ebene bilden und die Federelemente gegen die Längsseiten der Anschlußbeine der IC-Baueinheit und diese gegen die Stützfläche drückbar sind und
   d) mit einer an der Oberseite des Sockelkörpers ausgebildeten Anlagefläche, an welcher die Klemmplattenvorrichtung zumindest bei einer von der Lösestellung verschiedenen Stellung der Klemmplattenteile zumindest teilweise anliegt, dadurch gekennzeichnet,
   e) daß die Klemmplattenteile (25', 25") über die Spannstellung (27) hinaus in eine Arretierstellung (28) überführbar sind, in welcher die Klemmplattenteile (25', 25") aufeinanderzu nach unten in Richtung auf die Oberseite (3) des Sockelkörpers (1) geneigt sind und zumindest teilweise an der Anlagefläche (7) anliegen und
   f) daß jedes Federelement als massive Federzunge (23) mit einer an dem äußeren Klemmplattenrand (34', 34") anliegenden Vorderfläche (38) und einer der Stützfläche (19) zugewandten Rückenfläche (24) ausgebildet ist.

2. Steckverbinder nach Anspruch 1, dadurch gekennzeichnet, daß die Schwenkverbindung eine den Schwenkwinkel zwischen den Klemmplattenteilen (25', 25") von der Arretierstellung (28), über die Lösestellung (26) hinaus begrenzende Scharnierverbindung (29) aufweist, die aus an der Stirnseite der Klemmplattenteile (25', 25") angeordneten Scharnierlagern und einem Scharnierrastzapfen besteht.

3. Steckverbinder nach Anspruch 1 oder 2, dadurch gekennzeichnet, daß die Halteprofilelemente (36) von den Federzungen (23) gebildet sind.

4. Steckverbinder nach Anspruch 3, dadurch gekennzeichnet, daß das Halteprofil des Halteprofilelements (36) aus einem bogensegmentförmigen Abschnitt besteht, der am freien Ende (43) der Federzunge (23) ausgebildet den äußeren Klemmplattenrand (34', 34") zumindest teilweise umfaßt.

5. Steckverbinder nach Anspruch 4, dadurch gekennzeichnet, daß der bogensegmentförmige Abschnitt kreisbogensegmentförmig ausgebildet ist.

6. Steckverbinder nach Anspruch 4 oder 5, dadurch gekennzeichnet, daß der äußere Klemmplattenrand (34', 34") eine den bogensegmentförmigen Abschnitt entsprechende Bogenkontur (35) aufweist.

7. Steckverbinder nach einem der Ansprüche 4 bis 6, dadurch gekennzeichnet, daß die Federzunge (23) an der Rückenfläche (24) und/oder an der Vorderfläche (38) in Sockellängsrichtung verlaufende Querrillen (40) aufweist.

8. Steckverbinder nach einem der Ansprüche 1 bis 7, dadurch gekennzeichnet, daß an den Stirnseiten der Klemmplattenteile (25', 25") Betätigungsansätze (62) ausgebildet sind, mit welchen diese von der Lösestellung (26) in die Spannstellung (27) und darüber hinaus in die Arretierstellung (28) und zurück verschwenkbar sind.

9. Steckverbinder nach einem der Ansprüche 1 bis 8, dadurch gekennzeichnet, daß der an der Oberseite (3) des Sockelkörpers (1) ausgebildete, die Klemmplattenanlagefläche (7) aufweisende Anlageflächenabschnitt (6) eine bei der Arretierstellung (28) der Klemmplatten (25', 25") von deren Unterseite (33', 33") im Querschnitt gebildete Konturlinie zumindest teilweise diesem Querschnitt entsprechende Konturlinie aufweist.

10. Steckverbinder nach Anspruch 9, dadurch gekennzeichnet, daß die Konturlinie V-förmig ausgebildet ist und einen Winkel $\alpha$ kleiner als 180° und größer als 150°, vorzugsweise von 165° einschließt.

11. Steckverbinder nach Anspruch 9 oder 10, dadurch gekennzeichnet, daß der Anlagenflächenabschnitt (6) eine Federzungenanlagefläche (9) aufweist, gegen die die Federzunge (23) zumindest teilweise federdruckbelastet anlegbar ist.

12. Steckverbinder nach Anspruch 11, dadurch gekennzeichnet, daß sich die Federzungenanlagefläche (9) von dem mittleren Haltebereich (11) des Sockelkontakts (5, 46, 48, 55) bis zu der Klemmplattenanlagefläche (7) der Klemmplattenteile (25', 25") erstreckt.

13. Steckverbinder nach Anspruch 12, dadurch gekennzeichnet, daß die Vorderfläche (38) der Federzunge (23) mit der Federzungenanlagefläche (9) mindestens bei Spann- und Arretierstellung (27 und 28) der Klemmplattenteile (25', 25") einen spitzen Winkel $\beta$ größer als 0° und kleiner als 45°, vorzugsweise von 15° einschließt.

14. Steckverbinder nach einem der Ansprüche 1 bis 13, dadurch gekennzeichnet, daß die an der Oberseite (3) des Sockelkörpers (1) vorgesehene Stützfläche (19) von einem im oberen Endbereich des (10) des Sockelkontkats (5, 46, 48, 55) vorgesehenen Stützkontakt (47 ; 48 ; 50) gebildet ist.

15. Steckverbinder nach Anspruch 14, dadurch gekennzeichnet, daß der Lötanschlußstift (13) der mittlere Haltebereich (11) sowie der Stützkontakt (47 ; 48 ; 50) und/oder die Federzunge (28) einstückig ausgebildet sind.

16. Steckverbinder nach einem der Ansprüche 1 bis 15, dadurch gekennzeichnet, daß sich die Federzunge (23) bis in den unteren Endbereich (12) des Sockelkontakts (51) erstreckt.

17. Steckverbinder nach einem der Ansprüche 14 bis 16, dadurch gekennzeichnet, daß der Stützkontakt (50) einen massiven Kopfbereich (53) aufweist, an welchem die Stützfläche (19) ausgebildet ist.

18. Steckverbinder nach Anspruch 17, dadurch gekennzeichnet, daß die Stützfläche (19) in Form eines abgeplatteten Nasenvorspurngs (54) an dem Kopfbereich (53) ausgebildet ist.

19. Steckverbinder nach einem der Ansprüche 14 bis 17, dadurch gekennzeichnet, daß der Sockelkörper (1) eine V-förmige Einkerbung aufweist, welche auf der der Sockelmitte zugewandten Seite die Federzungenanlagefläche (9) und auf der der Sockelmittel abgewandten Seite eine Stützkontaktanlagefläche (51) bildet.

20. Steckverbinder nach Anspruch 19, dadurch gekennzeichnet, daß die Stützkontaktanlagefläche (51) mit der Rückseite (52) des Stützkontakts (50) einen spitzen Winkel $\gamma$ einschließt, der größer als 0° und kleiner als 30°, vorzugsweise 10° ist.

21. Steckverbinder nach einem der Ansprüche 14 bis 20, dadurch gekennzeichnet, daß der Stützkontakt (50) derart ausgebildet ist, daß er bei seiner Verschwenkung bis zur Stützkontaktanlagefläche (51) die Längsseite des Sockelkörpers (4) nicht überschreitet.

22. Steckverbinder nach einem der Ansprüche 8 bis 21, dadurch gekennzeichnet, daß die Betätigungszapfen (30) eine in eine Hebelvorrichtung (57) eines Prüfsockels (56) sich erstreckende Länge aufweist.

23. Steckverbinder nach Anspruch 22, dadurch gekennzeichnet, daß die Betätigungszapfen (30) von den Scharnierrastzapfen (63) gebildet sind.

**Claims**

1. Plug connector for I.C. assemblies
   a) comprising an insulating base block
   b) comprising a plurality of base contacts
   b1) which are disposed in the base block in correspondence with the multiple terminal legs of an I.C. assembly and
   b2) which each possess a lower end region constructed as a soldering pin which projects perpendicularly downwards from the underside of the base block,
   b3) furthermore possess a central holding region, which is fixed at least partly form-fittingly into the base block and extends through the base block and
   b4) finally possess an upper end region, which projects as terminal element from the upper side of the base block and is formed at least in a portion of its extent as a spring element which is displaceable along a spring path orientated transversely to the longitudinal direction of the base contact, the spring elements being disposed at such a distance from a support surface provided along the longitudinal sides on the upper side of the base block that the terminal legs of the I.C. assembly can be inserted therebetween, and
   c) comprising a clamping apparatus, which possesses at least two clamping plate parts with a pivotal connection orientated in their longitudinal direction and the outer clamping plate edges of which are encompassed by holding profile elements and bear, both in a release position and also in a clamping position of the clamping plate parts, against the spring elements, wherein, in the release position, the clamping plate parts are inclined upwardly away from the upper side of the base block in a roof shape and, in the clamped position, the clamping plate parts form a plane parallel to the underside of the base block, and the spring elements can be pressed against the longitudinal sides of the terminal legs of the I.C. assembly and these legs can be pressed against the supporting surface, and
   d) comprising a seating surface formed on the upper side of the base block, against which surface the clamping plate apparatus bears at least partly at least in a position of the clamping plate parts different from the release position, characterized in that
   e) that the clamping plate parts (25', 25") can be moved beyond the clamping position (27) into a locking position (28), in which the clamping plate parts (25', 25") are inclined towards each other and downwards towards the upper side (3) of the base block (1) and bear at least partly against the seating surface (7), and

f) that each spring element is formed as a solid spring tongue (23) having a front surface (38) bearing against the outer clamping plate edge (34', 34") and a rear surface (24) facing towards the support surface (19).

2. Plug connector according to claim 1, characterized in that the pivotal connection comprises a hinge connection (29), limiting the angle of pivot between the clamping plate parts (25', 25") from the locking position (28) through to the release position (26), which consists of hinge bearings disposed on the end faces of the clamping plate parts (25', 25") and of a hinge detent pin.

3. Plug connector according to claim 1 or 2, characterized in that the holding profile elements (36) are formed by the spring tongues (23).

4. Plug connector according to claim 3, characterized in that the holding profile of the holding profile element (36) consists of a curved segment-shaped portion, which is formed at the free end (43) of the spring tongue (23) and at least partially encompasses the outer edge (34', 34") of the clamping plate.

5. Plug connector according to claim 4, characterized in that the curved segment-shaped portion is constructed in the shape of a circular arc segment.

6. Plug connector according to claim 4 or 5, characterized in that the outer clamping plate edge (34', 34") possesses a curved contour (35) corresponding to the curved segment-shaped portion.

7. Plug connector according to one of claims 4 to 6, characterized in that the spring tongue (23) possesses, on its rear surface (24) and/or on the front surface (38), transverse grooves (40) orientated in the longitudinal direction of the base block.

8. Plug connector according to one of claims 1 to 7, characterized in that, at the end faces of the clamping plate parts (25', 25"), actuating projections (62) are formed, by which they can be pivoted from the release position (26) into the clamping position (27) and, beyond this, into the locking position (28) and back.

9. Plug connector according to one of claims 1 to 8, characterized in that the bearing surface section (6), formed on the upper face (3) of the base block (1) and possessing the clamping plate seating surface (7), has a contour line which, in the locking position (28) of the clamping plates (25', 25"), corresponds at least partly to the contour line formed by the cross-section of the underside (33', 33") of the clamping plates.

10. Plug connector according to claim 9, characterized in that the contour line is V-shaped and encloses an angle $\alpha$ smaller than 180° and larger than 150°, preferable of 165°.

11. Plug connector according to claim 9 or 10, characterized in that the seating surface section (6) possesses a spring tongue seating surface (9), against which the spring tongue (23) can be pressed, at least partly under spring pressure.

12. Plug connector according to claim 11, characterized in that the spring tongue seating surface (9) extends from the central holding region (11) of the base contact (5, 46, 48, 55) to the clamping plate seating surface (7) for the clamping plate parts (25', 25").

13. Plug connector according to claim 12, characterized in that the front surface (38) of the spring tongue (23) makes an angle $\beta$ greater than 0° and less than 45°, preferably of 15°, with the spring tongue seating surface (9) at least in the clamping and locking positions (27 and 28) of the clamping plate parts (25', 25").

14. Plug connector according to one of claims 1 to 13, characterized in that the support surface (19) provided on the upper side (3) of the base block (1) is formed of a support contact (47 ; 48 ; 50) provided in the upper end region (10) of the base contact (5, 46, 48, 55).

15. Plug connector according to claim 14, characterized in that the soldering pin (13), the central holding region (11) and the support contact (47 ; 48 ; 50) and/or the spring tongue (28) are formed in one piece.

16. Plug connector according to one of claims 1 to 15, characterized in that the spring tongue (23) extends as far as the lower end region (12) of the base contact (51).

17. Plug connector according to one of claims 14 to 16, characterized in that the support contact (50) has a solid head region (53), on which the support surface (19) is formed.

18. Plug connector according to claim 17, characterized in that the support surface (19) is constructed in the form of a flattened nose projection (54) in the head region (53).

19. Plug connector according to one of claims 14 to 17, characterized in that the base block (1) possesses a V-shaped notch, which constitutes, on the side towards the centre of the block, the spring tongue seating surface (9) and, on the side remote from the block centre, a support contact seating surface (51).

20. Plug connector according to claim 19, characterized in that the support contact seating surface (51) makes an acute angle $\gamma$ which is greater than 0° and less than 30°, preferably 10°, with the rear face (52) of the support contact (50).

21. Plug connector according to one of claims 14 to 20, characterized in that the support contact (50) is so formed that, in its pivotal movement as far as the support contact seating surface (51), it does not project beyond the longitudinal side of the base block (4).

22. Plug connector according to one of claims 8 to 21, characterized in that the actuating pin (30) has a length extending into a lever device (57) of a testing base block (56).

23. Plug connector according to claim 22, characterized in that the actuating pin (30) is formed by the hinge detent pin (63).

**Revendications**

1. Connecteur pour modules à C.I. comportant :
   a) un boîtier isolant
   b) plusieurs contacts de boîtier,
      b1) qui sont disposés dans le boîtier de la même façon que les sorties d'un module à C.I., et
      b2) qui présentent chacun une extrémité inférieure réalisée en broche à souder, en saillie verticale sur la base du boîtier,
      b3) qui comportent en outre une zone de maintien médiane, qui est fixée dans le boîtier au moins partiellement par sûreté de forme et traverse le boîtier, et
      b4) présentent enfin une extrémité supérieure en saillie sur la face supérieure du boîtier et réalisée sur une partie au moins de sa longueur en élément élastique, coulissant le long d'un trajet perpendiculaire au grand axe du contact de boîtier, les éléments élastiques étant disposés par rapport à une surface d'appui prévue le long des grands côtés, sur la face supérieure du boîtier, à une distance permettant l'insertion des sorties du module à C.I., et
   c) un dispositif de serrage comportant au moins deux plaques de serrage avec une charnière disposée suivant leur grand axe et dont les bords extérieurs sont entourés par des profilés de maintien et s'appliquent sur les éléments élastiques, tant dans une position d'ouverture que dans une position de serrage des plaques de serrage, ces dernières en position d'ouverture s'éloignant vers le haut de la face supérieure du boîtier et, en position de serrage, formant un plan parallèle à la base du boîtier, et les éléments élastiques s'appliquant sur les grands côtés des sorties du module à C.I. et ces dernières s'appliquant sur la face d'appui, et
   d) une face d'application formée sur la face supérieure du boîtier et sur laquelle le dispositif à plaques de serrage s'applique au moins partiellement, au moins dans une position des plaques de serrage autre que la position d'ouverture,
   et caractérisé en ce que :
   e) les plaques de serrage (25', 15") peuvent passer, au-delà de la position de serrage (27) dans une position de blocage (28) où elles sont inclinées vers le bas, en direction de la face supérieure (3) du boîtier (1) et s'appliquent au moins partiellement sur la face (7), et
   f) chaque élément élastique est réalisé sous forme d'une languette élastique massive (23) avec une face antérieure (38) s'appliquant sur le bord extérieur d'une plaque de serrage (34', 34") et une face postérieure (24) en regard de la face d'appui (19).

2. Connecteur selon revendication 1, caractérisé en ce que la liaison en pivotement comprend une charnière (29) qui limite l'angle de pivotement des plaques de serrage (25', 25") à partir de la position de blocage (28) jusqu'à la position d'ouverture (26), et qui est constitué par des charnons et une broche disposés sur la face frontale des plaques de serrage (25', 25").

3. Connecteur selon une des revendications 1 ou 2, caractérisé en ce que les profilés de maintien (36) sont constitués par les languettes élastiques (23).

4. Connecteur selon revendication 3, caractérisé en ce que le profilé de maintien (36) est constitué par un secteur en segment d'arc, réalisé à l'extrémité libre (43) de la languette élastique (23) et entourant au moins partiellement le bord extérieur d'une plaque de serrage (34', 34").

5. Connecteur selon revendication 4, caractérisé en ce que le secteur en segment d'arc est réalisé en segment d'arc de cercle.

6. Connecteur selon une des revendications 4 ou 5, caractérisé en ce que le bord extérieur des plaques de serrage (34', 34") présente un profil d'arc (35) correspondant au secteur en segment d'arc.

7. Connecteur selon une quelconque des revendications 4 à 6, caractérisé en ce que la languette élastique (23) présente sur la face postérieure (24) et/ou la face antérieure (38) des nervures transversales (40), suivant le grand axe du boîtier.

8. Connecteur selon une quelconque des revendications 1 à 7, caractérisé en ce que des saillies de manœuvre (62) sont formées sur les faces frontales des plaques de serrage (25', 25") et permettent de faire pivoter ces dernières de la position d'ouverture (26) dans la position de serrage (27), puis la position de blocage (28) et inversement.

9. Connecteur selon une quelconque des revendications 1 à 8, caractérisé en ce que le secteur (6) réalisé sur la face supérieure (3) du boîtier (1) et comportant la face d'application (7) des plaques de serrage présente un profil correspondant au moins partiellement au profil formé en coupe par la face inférieure (33', 33") des plaques de serrage (25', 25") en position de blocage (28).

10. Connecteur selon revendication 9, caractérisé en ce que le profil est en V formant un angle α inférieur à 180° et supérieur à 150°, et de préférence de 165°.

11. Connecteur selon une des revendications 9 ou 10, caractérisé en ce que le secteur (6) de la face d'application présente une face d'application (9) sur laquelle s'applique la languette élastique (23) chargée partiellement au moins par une pression élastique.

12. Connecteur selon revendication 11, caractérisé en ce que la face d'application (9) de la languette élastique s'étend de la zone de maintien médiane (11) du contact de boîtier (5, 46, 48, 55) à la face d'application (7) des plaques de serrage (25', 25").

13. Connecteur selon revendication 12, caractérisé en ce que la face antérieure (38) de la languette élastique (23) forme avec la face d'application (9) de la languette élastique, au moins dans la position de serrage ou de blocage (27, 28) des plaques de serrage (25', 25"), un angle aigu β

supérieur à 0° et inférieur à 45°, et de préférence de 15°.

14. Connecteur selon une quelconque des revendications 1 à 13, caractérisé en ce que la face d'appui (19) prévue sur la face supérieure (3) du boîtier (1) est formée par un contact d'appui (47 ; 48 ; 50) prévu à l'extrémité supérieure (10) du contact de boîtier (5, 46, 48, 55).

15. Connecteur selon revendication 14, caractérisé en ce que la broche à souder (13) de la zone de maintien médiane (11), le contact d'appui (47 ; 48 ; 50) et/ou la languette élastique (28) sont réalisés en une seule pièce.

16. Connecteur selon une quelconque des revendications 1 à 15, caractérisé en ce que la languette élastique (23) s'étend jusqu'à l'extrémité inférieure (12) du contact de boîtier (51).

17. Connecteur selon une quelconque des revendications 14 à 16, caractérisé en ce que le contact d'appui (50) présente une tête massive (53) sur laquelle est formée la face d'appui (19).

18. Connecteur selon revendication 17, caractérisé en ce que la face d'appui (19) est réalisée sous forme d'un bec (54) aplati sur la tête (53).

19. Connecteur selon une quelconque des revendications 14 à 17, caractérisé en ce que le boîtier (1) présente une encoche en V qui forme la face d'application (9) de la languette élastique sur le côté en regard du centre du boîtier et une face d'application (51) du contact d'appui sur le côté opposé au centre du boîtier.

20. Connecteur selon revendication 19, caractérisé en ce que la face d'application (51) du contact d'appui forme avec la face postérieure (52) du contact d'appui (50) un angle aigu $\gamma$, supérieur à 0° et inférieur à 30°, et de préférence de 10°.

21. Connecteur selon une quelconque des revendications 14 à 20, caractérisé en ce que le contact d'appui (50) est réalisé de façon à ne pas dépasser, pendant son pivotement jusqu'à la face d'application (51), le grand côté (4) du boîtier.

22. Connecteur selon une quelconque des revendications 8 à 21, caractérisé en ce que le tourillon de manœuvre (30) présente une longueur dans une tringlerie (57) d'un boîtier test (56).

23. Connecteur selon revendication 22, caractérisé en ce que le tourillon de manœuvre (30) est formé par les charnons (63).

## Fig. 1

## Fig. 2

1

# Fig. 3

23 — 37
24 — 38
44 — 23
11 — 43
42 —
— 12
14 —

5

# Fig. 4

5
40
10
38
11 —
42 — 41
— 12
14 —

# Fig. 5

25'     25''   22

34'          34''

35    29   30    35

# Fig. 9

17 — 20   25'

15 —
7
47 — 6
46 —
9   1
13 —
— 14

# Fig. 10

17 — 20   25'

47' —
15 — 7
6
49 —
1
48 —

Fig. 6

Fig. 7

Fig. 8

Fig. 11.

25"  20  19  17  37  35  8  9  38  β  50  53  54  52  51  15  44  49  4  11  1  7  3  2  10  23  55  12

0 093 290

**Fig. 12**

**Fig. 13**